# FASCICULE DE BREVET EUROPEEN

(11) **EP 1 538 656 B1**
(45) Date de publication et mention de la délivrance du brevet: **10.09.2008**
(21) Numéro de dépôt: 04292798.8
(22) Date de dépôt: 26.11.2004
(51) Int. Cl.: H01J 37/32, B01D 53/34, C23C 16/44

(54) **Système de traitement des gaz par plasma intégré dans une pompe à vide**
System zur Plasmabehandlung von Gasen in einer Vakuumpumpe
System for plasma treatment of gases in a vacuum pump

(30) Priorité: 01.12.2003 FR 0314176
(43) Date de publication de la demande: 08.06.2005
(73) Titulaire: Alcatel Lucent, 75008 Paris (FR)
(72) Inventeur: Maquin, Philippe, 74450 St. Jean de Sixt (FR); Neel, Thierry, 74960 Meythet (FR); Bernard, Roland, 74540 Viuz-La-Chiesaz (FR)
(74) Mandataire: Korakis-Ménager, Sophie

(56) Documents cités:
- EP-A- 0 781 599
- WO-A-99/16108
- FR-A- 2 825 295
- US-A- 5 672 322
- PATENT ABSTRACTS OF JAPAN vol. 2000, no. 20, 10 juillet 2001 (2001-07-10) & JP 2001 079335 A (UNIV CHUO), 27 mars 2001 (2001-03-27)
- PATENT ABSTRACTS OF JAPAN vol. 2000, no. 14, 5 mars 2001 (2001-03-05) & JP 2000 323466 A (APPLIED MATERIALS INC), 24 novembre 2000 (2000-11-24)
- PATENT ABSTRACTS OF JAPAN vol. 2000, no. 14, 5 mars 2001 (2001-03-05) & JP 2000 317265 A (APPLIED MATERIALS INC), 21 novembre 2000 (2000-11-21)
- PATENT ABSTRACTS OF JAPAN vol. 1999, no. 08, 30 juin 1999 (1999-06-30) & JP 11 076740 A (MITSUI CHEM INC), 23 mars 1999 (1999-03-23)

## Description

La présente invention concerne le traitement des gaz extraits des chambres à vide telles que les chambres de procédés utilisées pour la fabrication des semi-conducteurs.

Les gaz de procédé utilisés dans l'industrie des semi-conducteurs sont généralement toxiques, corrosifs ou même nuisibles à la couche d'ozone ou induisant un fort effet de serre. Il est donc nécessaire de traiter les gaz extraits avant tout rejet dans l'atmosphère, pour ne rejeter que des gaz peu nuisibles.

Jusqu'à présent, on a essentiellement traité les gaz de procédé dans des ensembles de traitement de gaz situés au refoulement des systèmes de pompage. Par conséquent, de tels ensembles de traitement de gaz doivent être conçus et dimensionnés pour traiter la totalité du flux sortant des systèmes de pompage.

Un premier inconvénient de ces ensembles de traitement de gaz connus est leur grand volume, nécessaire pour traiter la quantité importante de flux sortant. Ces ensembles de traitement de gaz sont pour cela délocalisés, c'est-à-dire placés dans un étage inférieur des usines de fabrication de semi-conducteurs, et reliés à la chambre de procédés par des canalisations longues et coûteuses. L'encombrement de ces ensembles de traitement de gaz rend impossible leur intégration à proximité des chambres de procédés.

Un second inconvénient est que le flux sortant des systèmes de pompage contient non seulement les gaz qui ont été extraits des chambres de procédés, mais contient en outre des gaz de purge qui sont introduits dans la chaîne de vide, entre la sortie des chambres de procédés et le refoulement des systèmes de pompage. Ces gaz de purge, ajoutés pour protéger les systèmes de pompage, perturbent l'efficacité du traitement, et compliquent encore ce traitement, conduisant à une augmentation supplémentaire du volume des ensembles de traitement des gaz.

Plus récemment, le document US 5,672,322 a proposé de prévoir un système de traitement de gaz extérieur à une pompe et que l'on vient connecter non pas au refoulement de la pompe mais entre deux étages successifs de la pompe, en prévoyant des canalisations de dérivation.

Le traitement des gaz peut ainsi être amélioré, car on peut traiter les gaz nocifs avant leur dilution par les gaz de purge dans les étages successifs de la pompe.

Mais ces systèmes de traitement de gaz en dérivation entre des étages successifs de la pompe, qui sont seulement partiellement intégrés à la pompe, présentent encore des inconvénients importants qui sont expliqués ci-après.

En particulier, avec un tel traitement de gaz en dérivation entre des étages successifs de la pompe, le fonctionnement de la pompe elle-même est apparemment dégradé, car on constate une réduction des capacités de pompage, de la vitesse de pompage, et des performances de vide. Le système de pompage est ainsi perturbé par la présence du système de traitement de gaz, et un meilleur traitement de gaz se fait alors au détriment de l'efficacité du pompage.

Le problème proposé par la présente invention est de concevoir une nouvelle structure de système de traitement des gaz par plasma qui assure à la fois un meilleur traitement des gaz, et une conservation des propriétés du système de pompage notamment pour ce qui concerne les capacités de pompage, la vitesse de pompage, les performances de vide, tout en réduisant de façon très sensible la taille des moyens de traitement de gaz, afin de permettre leur intégration au plus près des chambre de procédés.

Pour cela, l'invention résulte d'une analyse des inconvénients des systèmes connus, en particulier du système décrit dans le document US 5,672,322.

Il apparaît que la réduction des performances du système de pompage résulte du fait même que le système de traitement des gaz est placé à l'extérieur du système de pompage, et lui est raccordé par des canalisations de dérivation. Le système de traitement des gaz et les canalisations de dérivation constituent une section de passage imposé que les gaz pompés doivent traverser, et qui tend donc à s'opposer au libre passage des gaz pompés entre deux étages successifs d'une pompe. Cette résistance explique la baisse de performance du système de pompage, et cette baisse de performance est d'autant plus sensible lorsque les canalisations de dérivation et le système de traitement des gaz présentent une section transversale réduite.

On pourrait donc songer à augmenter la section transversale des canalisations de dérivation et du système de traitement des gaz. Mais alors ce volume élevé rend plus difficile certains traitements des gaz par un plasma, car il faut alors disposer d'une source de plasma à haute puissance, qui induit d'une part une grande consommation d'énergie, et d'autre part l'adaptation de moyens générateurs présentant eux-mêmes un volume additionnel non négligeable.

L'idée essentielle de l'invention est alors de réaliser au moins un traitement partiel des gaz au passage entre deux étages successifs d'une pompe à vide du système de pompage, en plaçant, à l'intérieur même de la pompe à vide, la source de plasma qui assure la décomposition des gaz nocifs.

Ainsi, l'invention propose un système de pompage et de traitement des gaz, comprenant au moins un groupe de pompage, ayant un corps de pompe à vide dans lequel sont prévues une d'étages de pompage connectés aérauliquement série les uns à la suite des autres par des canalisations inter-étages, et au moins un système de traitement des gaz pompés. Le système de traitement des gaz pompés comprend au moins une source de plasma, logée dans le volume intérieur d'un étage à l'intérieur du corps de pompe à vide du groupe de pompage.

De préférence, l'étage contenant la source de plasma est un étage basse pression. De la sorte, on agit sur les gaz nocifs avant même leur dilution dans les gaz de purge ou de traitement.

On peut avantageusement prévoir un système de pompage et de traitement des gaz comprenant plusieurs sources de plasma insérées respectivement dans des étages, notamment des étages basse pression, et dans plusieurs canalisations inter-étages successives entre des étages, notamment des premiers étages basse pression, du groupe de pompage. Selon une variante, une source de plasma peut être logée en outre dans une canalisation inter-étages à l'intérieur du corps de pompe à vide du groupe de pompage.

Le traitement des gaz par plasma dans les canalisations inter-étages d'un groupe de pompage peut être amélioré en combinant la décomposition des gaz par le plasma à une injection de gaz de neutralisation, qui empêche la recomposition des gaz décomposés par le plasma, et qui les recompose suivant une réaction chimique contrôlée en sous-produits moins nocifs. Selon l'invention, on peut alors profiter avantageusement de la présence d'un circuit de purge, en prévoyant une source de gaz de neutralisation adaptée pour injecter le gaz de neutralisation dans le circuit de purge lui-même qui l'introduit dans le groupe de pompage.

Un autre avantage de l'invention est alors de réduire la quantité de gaz nocifs présents dans le groupe de pompage, et par conséquent de réduire aussi la quantité nécessaire de gaz de neutralisation qu'il faut introduire dans le groupe de pompage pour neutraliser la quantité restante de gaz nocifs.

Selon un mode de réalisation avantageux, on peut prévoir des moyens de commande qui adaptent la vitesse de rotation du groupe de pompage pour optimiser les pressions internes et les paramètres plasma respectifs dans la canalisation inter-étages et/ou l'étage, afin d'augmenter le rendement de conversion des espèces gazeuses par le plasma.

En alternative ou en complément, les moyens de commande peuvent adapter, en fonction de la vitesse de pompage, la puissance de génération de plasma délivrée par la source de plasma, afin d'augmenter le rendement de conversion des espèces gazeuses par le plasma.

En complément, au moins un dispositif de mesure par spectrométrie optique du plasma peut être associé à au moins une source de plasma, pour mesurer, contrôler et optimiser les réactions gazeuses dans la canalisation inter-étages et/ou l'étage, en agissant sur la vitesse du groupe de pompage et/ou sur la puissance de la source de plasma, et/ou sur la quantité de gaz de neutralisation injectée par la source de gaz de neutralisation dans le circuit de purge.

L'invention s'applique a priori à tous types de groupes de pompage multiétagés à canalisations inter-étages, notamment à des groupes de pompage de type roots multiétagés, par exemple une pompe de référence "Alcatel Dry Pump A300" produite et distribuée par la société ALCATEL.

D'autres objets, caractéristiques et avantages de la présente invention ressortiront de la description suivante de modes de réalisation particuliers faite en relation avec les figures annexées illustrant un système de pompage muni d'un dispositif de traitement des gaz selon l'invention.

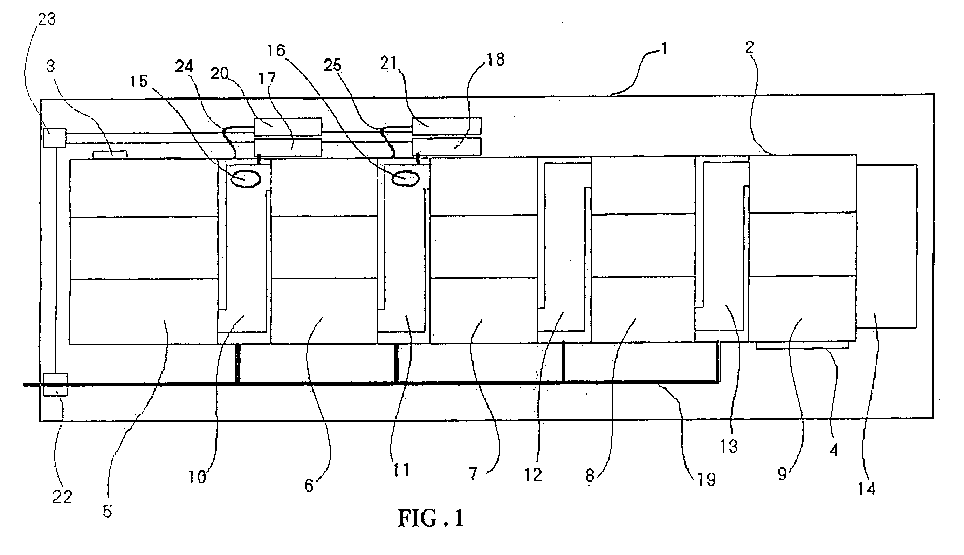

La figure 1 représente un système de pompage muni d'un dispositif de traitement des gaz dans lequel les sources de plasma sont logées dans les canalisations inter-étages.

La figure 2 représente un système de pompage muni d'un dispositif de traitement des gaz selon l'invention dans lequel les sources de plasma sont logées dans les étages.

Le système de pompage représenté sur la figure comprend, dans un boîtier 1, un groupe de pompage 2 ayant un corps de pompe à vide dans lequel sont prévus, entre une entrée de pompage 3 et une sortie de pompage 4, une pluralité d'étages de pompage tels que les étages 5, 6, 7, 8 et 9.

Les étages de pompage sont connectés aérauliquement en série les uns à la suite des autres par des canalisations inter-étages respectives 10, 11, 12 et 13 prévues à l'intérieur du corps du groupe de pompage 2.

Les étages de pompage 5 à 9 comprennent chacun un stator et un rotor. Les rotors, de façon connue, sont couplés mécaniquement sur un même arbre entraîné en rotation par un moteur à vitesse variable 14 ou fixe.

Les canalisations inter-étages 10 et 11, qui relient respectivement les étages 5 et 6 ou les étages 6 et 7 à plus basse pression du groupe de pompage, contiennent deux sources de plasma respectives 15 et 16 adaptées pour générer, dans les gaz pompés à basse pression contenus dans les canalisations inter-étages 10 et 11, un plasma capable de décomposer les gaz nocifs pompés. Les sources de plasma respectives 15 et 16 sont pour cela alimentées par un générateur haute fréquence respectif 17 ou 18, et comprennent des moyens de couplage haute fréquence pour transmettre au volume intérieur des canalisations inter-étages 10 et 11 l'énergie haute fréquence capable d'exciter les molécules gazeuses et de produire le plasma.

Par le fait que les canalisations inter-étages 10 et 11 ont une section transversale relativement réduite, les sources de plasma 15 et 16 peuvent aisément être réalisées par tous moyens connus adaptés pour la génération d'un plasma dans de tels volumes réduits.

Le système crée ainsi, dans les canalisations inter-étages 10 et 11, un plasma approprié pour décomposer certains gaz nocifs provenant d'une chambre à vide connectée à l'entrée de pompage 3 du groupe de pompage.

On voit que les sources de plasma 15 et 16 sont intégrées à l'intérieur même du groupe de pompage. Les générateurs haute fréquence 17 et 18 peuvent être intégrés à l'intérieur du boîtier 1, car leur volume peut être réduit, par le fait que la puissance haute fréquence nécessaire à la génération du plasma dans les faibles volumes des canalisations inter-étages 10 et 11 est elle-même faible.

Grâce à cette intégration des sources de plasma 15 et 16 à l'intérieur même des canalisations inter-étages 10 et 11, aucune conductance supplémentaire n'est ajoutée au dispositif de la pompe à vide, de sorte que les gaz pompés parcourent le groupe de pompage aussi aisément qu'en l'absence d'un dispositif de traitement des gaz. Le plasma lui-même généré dans les sources de plasma 15 et 16 ne constitue pas un frein au déplacement des gaz.

De la sorte, la capacité et la vitesse de pompage du groupe de pompage ne sont pas affectées par la présence du dispositif de traitement des gaz selon l'invention.

Du fait que le plasma n'a besoin d'être créé dans les canalisations inter-étages que sur une longueur réduite et dans un volume à section transversale réduite, on bénéficie de la faible dimension de la source de plasma pour que le générateur haute fréquence 17 ou 18 nécessaire ait lui-même une puissance réduite, et donc un volume très réduit.

En intégrant plusieurs sources de plasma 15 et 16 insérées respectivement dans plusieurs canalisations inter-étages successives entre des premiers étages basse pression de la pompe à vide, on favorise le traitement des gaz en assurant ce traitement avant toute dilution importante dans des gaz de purge ou des gaz de neutralisation. Egalement, dans les étages basse pression de la pompe à vide, on obtient une décharge électroluminescente de forte intensité avec une puissance optimisée, pour une décomposition efficace des gaz nocifs.

Comme on le fait généralement dans les pompes à vide destinées à pomper des gaz hors des chambres de procédés dans la fabrication de semi-conducteurs, on prévoit d'injecter de l'azote ou un autre gaz de purge dans les canalisations inter-étages 10, 11, 12 et 13, par un circuit de purge 19. Le gaz de purge a pour but d'éviter le dépôt de produits nocifs sur les éléments de la pompe, et d'éviter également la corrosion progressive des éléments de la pompe.

Par le fait que les sources de plasma 15 et 16 sont placées dans les canalisations inter-étages des premiers étages basse pression de la pompe, il en résulte que le plasma agit sur des gaz dans lesquels l'azote est en plus faible quantité. Il en résulte également que le plasma est susceptible de créer une plus faible proportion de composés de type NOX, qui sont nocifs.

Le circuit de purge 19 peut en outre être utilisé pour l'injection d'un gaz de neutralisation tel que l'oxygène ou la vapeur d'eau, pour assurer, en présence du plasma, une meilleure décomposition des gaz tels que CF₄ par la réaction :
1) CF₄ + 2 H₂O → CO₂ + 4HF
2) CF₄ + 2 H₂O → CO + 4HF + ½ O

Pour cela, le système de pompage selon l'invention peut comprendre, comme représenté sur la figure, un circuit de purge 19 et une source de gaz de neutralisation 22 adaptée pour injecter un gaz de neutralisation dans le circuit de purge 19. Le circuit de purge 19 assure l'introduction du gaz de neutralisation dans le groupe de pompage.

Le traitement des gaz peut être réalisé en mode multiplexé sur les différents inter-étages de la pompe à vide, par exemple dans les canalisations inter-étages 10 et 11, ou bien dans les canalisations inter-étages 10, 11 et 12, en fonction de l'efficacité de la création du plasma et des différentes pressions dans chaque partie de la pompe à vide. Les conditions dans la pompe à vide peuvent en effet varier en fonction des étapes des procédés nécessitant le pompage des gaz, et l'on peut ainsi adapter le traitement des gaz aux conditions régnant dans la chambre de procédés. Les générateurs haute fréquence 17 et 18 sont pour cela pilotés par des moyens de commande 23 tels qu'un processeur associé à des mémoires et un programme enregistré, le programme étant adapté pour adapter le fonctionnement ou l'arrêt des générateurs haute fréquence 17 et 18 en fonction des conditions optimales de traitement des gaz qu'il faut respecter.

En alternative ou en complément, les moyens de commande 23 peuvent piloter également le moteur 14 pour adapter la vitesse de rotation de la pompe afin d'optimiser les pressions internes et les paramètres plasma respectifs dans les canalisations inter-étages 10 et/ou 11. On peut ainsi augmenter le rendement de conversion des espèces gazeuses par le plasma.

En alternative ou en complément, les moyens de commande 23 peuvent également adapter, en fonction de la vitesse de pompage, la puissance de génération de plasma délivrée par les sources de plasma, en pilotant les générateurs haute fréquence 17 et 18. On peut ainsi augmenter également le rendement de conversion des espèces gazeuses par le plasma.

Enfin, on peut avantageusement assurer un contrôle en temps réel du traitement des gaz par une mesure de spectrométrie optique du plasma. Pour cela, un dispositif de mesure peut être associé à l'électrode haute fréquence de chaque source de plasma 15 ou 16. Le dispositif de mesure peut être par exemple un spectromètre optique 20 ou 21 raccordé à une fibre optique 24 ou 25 pour recueillir la radiation lumineuse émise par la source de plasma correspondante 15 ou 16. Les informations recueillies par les spectromètres optiques 20 et 21 sont envoyées au dispositif de commande 23 qui peut, en réponse, adapter la vitesse du moteur 14, la puissance des générateurs haute fréquence 17 et 18, l'injection de gaz de neutralisation par la source de gaz de neutralisation 22. On peut ainsi encore mieux contrôler et optimiser les réactions gazeuses dans les canalisations inter-étages.

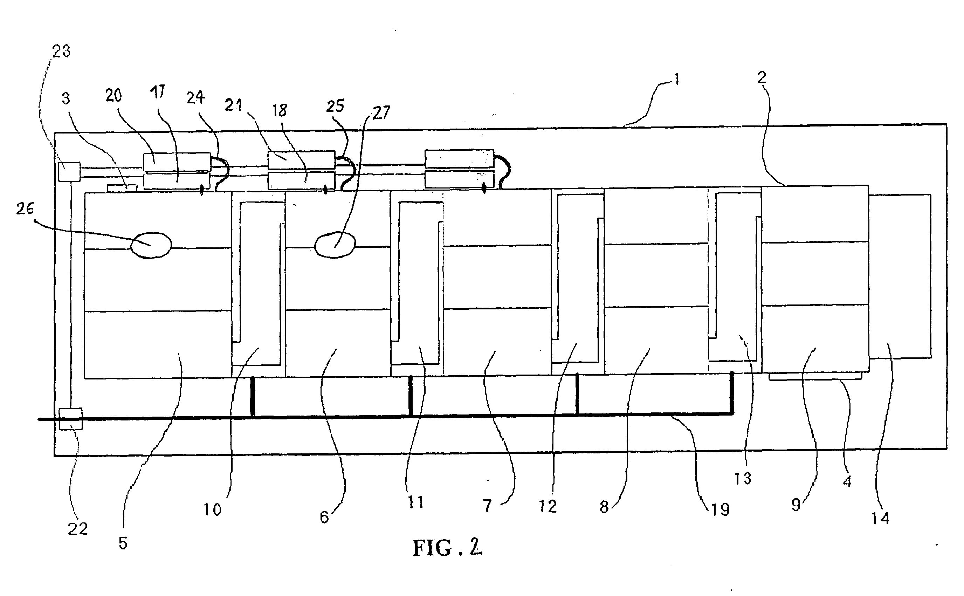

Selon l'invention, le système de pompage représenté sur la figure 2 comprend, dans un boîtier 1, un groupe de pompage 2 ayant un corps de pompe à vide dans lequel sont prévus, entre une entrée 3 et une sortie 4 de pompage, une pluralité d'étages de pompage 5, 6, 7, 8 et 9.

Les étages 5 et 6 à plus basse pression du groupe de pompage 2, contiennent deux sources de plasma respectives 26 et 27 adaptées pour générer, dans les gaz pompés à basse pression contenus dans les étages 5 et 6, un plasma capable de décomposer les gaz nocifs pompés à basse pression contenus dans les étages 5 et 6. Les sources de plasma 26 et 27 sont pour cela alimentées respectivement par un générateur haute fréquence 17 ou 18, et comprennent des moyens de couplage haute fréquence pour transmettre au volume intérieur des étages 5 et 6, l'énergie haute fréquence capable d'exciter les molécules gazeuses et de produire le plasma.

Par le fait que les étages 5 et 6 ont un volume relativement réduit, les sources de plasma 26 et 27 peuvent aisément être réalisées par tous moyens connus adaptés pour la génération d'un plasma dans de tels volumes réduits.

Le système selon l'invention crée ainsi, dans les étages 5 et 6, un plasma approprié pour décomposer certains gaz nocifs provenant d'une chambre à vide connectée à l'entrée de pompage 3 du groupe de pompage 2.

On voit que les sources de plasma 26 et 27 sont intégrées à l'intérieur même du corps de pompe à vide du groupe de pompage 2. Les générateurs haute fréquence 17 et 18 peuvent être intégrés à l'intérieur du boîtier 1, car leur volume peut être réduit, par le fait que la puissance haute fréquence nécessaire à la génération du plasma dans les faibles volumes des étages 5 et 6 est elle-même faible.

Grâce à cette intégration des sources de plasma 26 et 27 à l'intérieur même des étages 5 et 6, aucune conductance supplémentaire n'est ajoutée au dispositif de la pompe à vide, de sorte que les gaz pompés parcourent le groupe de pompage 2 aussi aisément qu'en l'absence d'un dispositif de traitement des gaz. Le plasma lui-même généré par les sources de plasma 26 et 27 ne constitue pas un frein au déplacement des gaz.

De la sorte, la capacité et la vitesse de pompage du groupe de pompage ne sont pas affectées par la présence du dispositif de traitement des gaz selon l'invention.

Du fait que le plasma n'a besoin d'être créé que dans un volume réduit dans les étages 5 et 6, on bénéficie de la faible dimension de la source de plasma 26 ou 27 pour que le générateur haute fréquence 17 ou 18 respectivement nécessaire ait lui-même une puissance réduite, et donc un volume très réduit.

En intégrant plusieurs sources de plasma 26 et 27 insérées respectivement dans des premiers étages basse pression 5 et 6 successifs de la pompe à vide, on favorise le traitement des gaz en assurant ce traitement avant toute dilution importante dans des gaz de purge ou des gaz de neutralisation. Également, dans les étages 5 et 6 basse pression de la pompe à vide, on obtient une décharge électroluminescente de forte intensité avec une puissance optimisée, pour une décomposition efficace des gaz nocifs.

On peut aussi prévoir d'injecter de l'azote ou un autre gaz de purge dans les canalisations inter-étages 10, 11, 12 et 13, par un circuit de purge 19 comme décrit précédemment.

Par le fait que les sources de plasma 26 et 27 sont placées de préférence dans les premiers étages 5 et 6 basse pression de la pompe, il en résulte que le plasma agit sur des gaz dans lesquels l'azote est en plus faible quantité. Il en résulte également que le plasma est susceptible de créer une plus faible proportion de composés de type NOX, qui sont nocifs.

Selon l'invention, le traitement des gaz peut être réalisé en mode multiplexé sur les différents étages de la pompe à vide, par exemple dans l'étage 5, ou bien dans l'étage 6, 7, 8 et/ou 9, en fonction de l'efficacité de la création du plasma et des différentes pressions dans chaque partie de la pompe à vide. Les conditions dans la pompe à vide peuvent en effet varier en fonction des étapes des procédés nécessitant le pompage des gaz, et l'on peut ainsi adapter le traitement des gaz aux conditions régnant dans la chambre de procédés. Les générateurs haute fréquence 17 et 18 sont pour cela pilotés par des moyens de commande 23 comme décrit précédemment.

En alternative ou en complément, les moyens de commande 23 peuvent piloter également le moteur 14 pour adapter la vitesse de rotation de la pompe afin d'optimiser les pressions internes et les paramètres plasma respectifs dans les étages 5 et/ou 6.

Enfin, on peut avantageusement assurer un contrôle en temps réel du traitement des gaz par une mesure de spectrométrie optique du plasma. Pour cela, un dispositif de mesure, tel qu'un spectromètre optique, peut être associé à chaque source de plasma 26 ou 27 comme décrit précédemment.

L'invention permet ainsi de réaliser des systèmes de pompage et de traitement des gaz de taille suffisamment petite pour être placés directement dans le sol à proximité des chambres de procédés dans les installations de fabrication de semi-conducteurs.

L'invention s'applique non seulement à des systèmes de pompage neufs, intégrés dans des équipements neufs, mais également à des systèmes de pompage existants, dans lesquels le dispositif de traitement des gaz pompés peut être intégré par remplacement des pompes existantes.

Le dispositif de l'invention permet de réduire les émissions de gaz à effet de serre de type PFC, souvent utilisés dans les équipements semi-conducteurs pour les étapes de gravure diélectrique et de nettoyage des procédés de dépôt CVD.

L'intégration des sources de plasma dans la pompe à vide elle-même après le premier étage de compression permet de réduire la rétrodiffusion des gaz vers la chambre de procédés.

La présente invention n'est pas limitée aux modes de réalisation qui ont été explicitement décrits, mais elle en inclut les diverses variantes qui sont à la portée de l'homme du métier.

## Revendications

1. Système de pompage et de traitement des gaz, comprenant au moins un groupe de pompage (2), ayant un corps de pompe à vide dans lequel sont prévues une pluralité d'étages de pompage (5, 6, 7, 8, 9) connectés aérauliquement en série les uns à la suite des autres par des canalisations inter-étages, et au moins un système de traitement des gaz pompés comprenant au moins une source de plasma (15, 16, 26, 27), **caractèrisé en ce que** cette source de plasma est logée dans le volume intérieur d'un étage (5, 6) à l'intérieur du corps de pompe à vide du groupe de pompage (2).

2. Système de pompage et dé traitement des gaz selon la revendication 1, comprenant en outre un circuit de purge (19), et une source de gaz de neutralisation (22) adaptée pour injecter un gaz de neutralisation dans le circuit de purge (19) pour introduire ledit gaz de neutralisation dans le groupe de pompage (2).

3. Système de pompage et de traitement des gaz selon l'une des revendications 1 et 2, comprenant en outre des moyens de commande (23) des générateurs haute fréquence (15, 16) pour adapter la puissance de génération de plasma délivrée par la source de plasma (15, 16, 26, 27) en fonction de la vitesse de pompage.

4. Système de pompage et de traitement des gaz selon l'une des revendications précédentes, dans lequel la source de plasma (26, 27) est contenue dans un étage(5, 6) de plus basse pression parmi les étages (5, 6, 7, 8, 9) du groupe de pompage (2).

5. Système de pompage et de traitement des gaz selon l'une des revendications précédentes, comprenant plusieurs sources de plasma (15, 16, 26, 27).

6. Système de pompage et de traitement des gaz selon la revendication 5, dans lequel une source de plasma (15, 16) est logée en outre dans une canalisation inter-étages (10, 11) à l'intérieur du corps de pompe à vide du groupe de pompage (2).

7. Système de pompage et de traitement des gaz selon la revendication 6, dans lequel la canalisation inter-étages (10, 11) relie deux étages (5, 6 et 6, 7) de plus basse pression parmi les étages (5, 6, 7, 8, 9) du groupe de pompage (2).

8. Système de pompage et de traitement des gaz selon l'une quelconque des revendications 6 et 7, comprenant en outre des moyens de commande (23) du moteur (14) pour adapter la vitesse de rotation du groupe de pompage, afin d'optimiser les pressions internes dans les canalisations inter-étages (10 et/ou 11) et les paramètres plasma dans les canalisations inter-étages (10 et/ou 11).

9. Système de pompage et de traitement des gaz selon l'une quelconque des revendications 6 à 8, comprenant en outre au moins un dispositif de mesure par spectrométrie optique du plasma (20, 21) associé à au moins une source de plasma (15, 16, 26, 27), qui mesure, contrôle et optimise les réactions gazeuses dans la canalisation inter-étages (10, 11), en agissant sur la vitesse du groupe de pompage (2), et/ou sur la puissance de la source de plasma (15, 16, 26, 27), et/ou sur la quantité de gaz de neutralisation.

## Claims

1. A system for pumping and treating gas, comprising at least one pumping group (2) having a vacuum pump body within which are provided a plurality of pumping stages (5, 6, 7, 8, 9) connected aeraulically in series one after another by inter-stage tubes, and at least one system for treating pumped gas comprising at least one source of plasma (15, 16, 26, 27), **characterized in that** said source of plasma is housed within the interior volume of a stage (5, 6) within the vacuum pump body of the pumping group (2).

2. A system for pumping and treating gas according to claim 1, further comprising a purging circuit (19) and a source of neutralizing gas (22) designed to inject a neutralizing gas into the purging circuit (19) in order to introduce this gas into the pumping group (2).

3. A system for pumping and treating gas according to one of the claims 1 and 2, further comprising control means (23) for controlling high-frequency generators (15, 16) for adjusting the generation power of the plasma delivered by the plasma source (15, 16, 26, 27) as a function of pumping speed.

4. A system for pumping and treating gas according to one of the preceding claims, wherein the source of plasma (26, 27) is contained within a stage (5, 6) having the lowest pressure among the stages (5, 6, 7, 8, 9) of the pumping group (2).

5. A system for pumping and treating gas according to one of the preceding claims, comprising multiple sources of plasma (15, 16, 26, 27).

6. A system for pumping and treating gas according to claim 5, wherein one source of plasma (15, 16) is further housed within an inter-stage tube (10, 11) within the vacuum pump body of the pumping group (2).

7. A system for pumping and treating gas according to claim 6, wherein the inter-stage tube (10, 11) connects two stages (5, 6 and 6, 7) having the lowest pressure among the stages (5, 6, 7, 8, 9) of the pumping group (2).

8. A system for pumping and treating gas according to one of the claims 6 and 7, further comprising control means (23) for controlling the motor (14) in order to adjust the rotating speed of the pumping group, in order to optimize the internal pressure within the inter-stage tubes (10 and/or 11) and the plasma parameters within the inter-stage tubes (10 and/or 11).

9. A system for pumping and treating gas according to one of the claims 6 to 8, further comprising a plasma optical emission spectrometry measurement device (20, 21) associated with at least one source of plasma (15, 16, 26, 27) which measures, controls, and optimizes the gas reactions within the inter-stage tube (10, 11) by acting on the speed of the pumping group (2) and/or on the power of the plasma source (15, 16, 26, 27), and/or on the quantity of the neutralizing gas.

## Patentansprüche

1. System zum Pumpen und zum Behandeln von Gasen, welches mindestens eine Pumpgruppe (2) mit einem Vakuumpumpenkörper, in welchem eine Vielzahl von Pumpebenen (5, 6, 7, 8, 9) vorgesehen sind, die lufitechnisch eine nach der anderen in Reihe über Leitungen zwischen den Ebenen verbunden sind, umfasst, und mindestens ein System zur Behandlung der gepumpten Gase, welches mindestens eine Plasmaquelle (15, 16, 26, 27) umfasst, **dadurch gekennzeichnet, dass** diese Plasmaquelle in einem Innenvolumen einer Ebene (5, 6) innerhalb des Vakuumpumpenkörpers der Pumpgruppe (2) angeordnet ist.

2. System zum Pumpen und zum Behandeln von Gasen nach Anspruch 1, welches weiterhin ein Entlüftungssystem (19) und eine Sperrgasquelle (22) zum Einspritzen eines Sperrgases in das Entlüfturgssystem (19) zum Einspritzen des besagten Sperrgases in die Pumpgruppe (2) umfasst.

3. System zum Pumpen und zum Behandeln von Gasen nach einem der Ansprüche 1 und 2, welches weiterhin Mittel zum Steuern (23) der Hochfrequenzgeneratoren (15, 16) umfasst, um die von der Plasmaquelle (15, 16, 26, 27) gelieferte Plasmaerzeugungsleistung entsprechend de Pumpgeschwindigkeit anzupassen.

4. System zum Pumpen und zum Behandeln von Gasen nach einem der vorstehenden Ansprüche, in welchem sich die Plasmaquelle (26, 27) in einer Ebene (5, 6) mit dem niedrigsten Druck der Ebenen (5, 6, 7, 8, 9) der Pumpgruppe (2) befindet.

5. System zum Pumpen und zum Behandeln von Gasen nach einem der vorstehenden Ansprüche, weiches mehrere Plasmaquellen (15, 16, 26, 27) umfasst.

6. System zum Pumpen und zum Behandeln von Gasen nach Anspruch 5, in welchem sich eine Plasmaquelle (15, 16) ebenfalls in einer Leitung zwischen den Ebenen (10, 11) innerhalb des Vakuumpumpenkörpers der Pumpgruppe (2) befindet.

7. System zum Pumpen und zum Behandeln von Gasen nach Anspruch 6, in welchem die Leitung zwischen den Ebenen (10, 11) zwei Ebenen (5, 6 und 6,7) mit dem niedrigsten Druck der Ebene (5, 6, 7, 8, 9) der Pumpgruppe (2) miteinander verbindet.

8. System zum Pumpen und zum Behandeln von Gasen nach einem beliebigen der Ansprüche 6 und 7, welches weiterhin Mittel zum Steuern (23) des Motors (14) zum Anpassen der Drehgeschwindigkeitder Pumpgruppe umfasst, um die internen Drücke in den Leitungen zwischen den Ebenen (10 und/oder 11) sowie die Plasmaparameter in den Leitungen zwischen den Ebenen (10 und/oder 11) zu optimieren.

9. System zum Pumpen und zum Behandeln von Gasen nach einem beliebigen der Ansprüche 6 bis 8, welches weiterhin mindestens eine Einrichtung zum Messen des Plasmas (20, 21) mittels optischer Spektrometrie, welche mit mindestens einer Plasmaquelle (15, 16, 26, 27) verbunden ist und die Gasreaktionen in den Leitungen zwischen den Ebenen (10, 11) durch Einwirken auf die Geschwindigkeit der Pumpgruppe (2) und/oder auf die Leistung der Plasmaquelle (15, 16, 26, 27) und/oder auf die Sperrgasmenge misst, prüft und optimiert, umfasst.
